Europäisches Patentamt

(19) European Patent Office

Office européen des brevets

(11) Publication number : **0 237 206 B1**

# (12) EUROPEAN PATENT SPECIFICATION

(45) Date of publication of patent specification :
**11.09.91 Bulletin 91/37**

(21) Application number : **87301351.0**

(22) Date of filing : **17.02.87**

(51) Int. Cl.$^5$ : **C04B 41/90,** C30B 25/08,
C03C 17/38, C23C 14/58,
C23C 14/02, C23C 28/00,
C23C 18/08

(54) **Protected gold coating and process.**

(30) Priority : **03.03.86 US 835610**

(43) Date of publication of application :
**16.09.87 Bulletin 87/38**

(45) Publication of the grant of the patent :
**11.09.91 Bulletin 91/37**

(84) Designated Contracting States :
**AT BE CH DE ES FR GB GR IT LI LU NL SE**

(56) References cited :
**EP-A- 0 147 967**
**CH-A- 423 296**

(56) References cited :
**DE-A- 1 806 821**
**DE-A- 1 912 938**
**FR-A- 1 046 097**
**US-A- 3 390 969**

(73) Proprietor : **APPLIED MATERIALS, INC.**
**3050 Bowers Avenue**
**Santa Clara California 95051 (US)**

(72) Inventor : **Lorimer, d'Arcy H.**
**2584 Knightsbridge Lane**
**Santa Clara California 95051 (US)**

(74) Representative : **Bayliss, Geoffrey Cyril et al**
**BOULT, WADE & TENNANT 27 Furnival Street**
**London EC4A 1PQ (GB)**

Jouve, 18, rue Saint-Denis, 75001 PARIS

## Description

The present invention relates to a vacuum evaporation process for applying gold coatings to materials such as quartz and, in particular, to such a process and a resultant layered gold coating characterized by reproducibility, high reflectivity, strong adhesion and resistance to erosion and corrosion.

The need for the present gold coating and associated process arose in the semiconductor fabrication industry and specifically with respect to the recent use of reflective gold coatings which are applied to inductively heated quartz epitaxial growth reactors to enhance performance thereof. The use and advantages of such coatings are described in US-A-4579080, entitled "Induction Heated Reactor System for Chemical Vapor Desposition".

The use of a reflective coating is derived from the need to eliminate or substantially reduce the thermal gradients across semiconductor wafers during thermal processing thereof. Thermal stress in semiconductor wafers during processing can generate dislocations which propagate along the crystallographic lattice in characteristic, frequently visible slip planes.

In the past, thermal stress-induced crystallographic slip has manifested itself in high temperature processing such as the high temperature growth of epitaxial silicon layers which are used, for example, to form bipolar IC components, Stress-induced slip itself, as well as its unwanted function of acting as a sink for impurities, lead to defective transistors which in turn lead to defective circuits on individual IC chips and defective chips, thereby reducing the yield in the semiconductor processing operation.

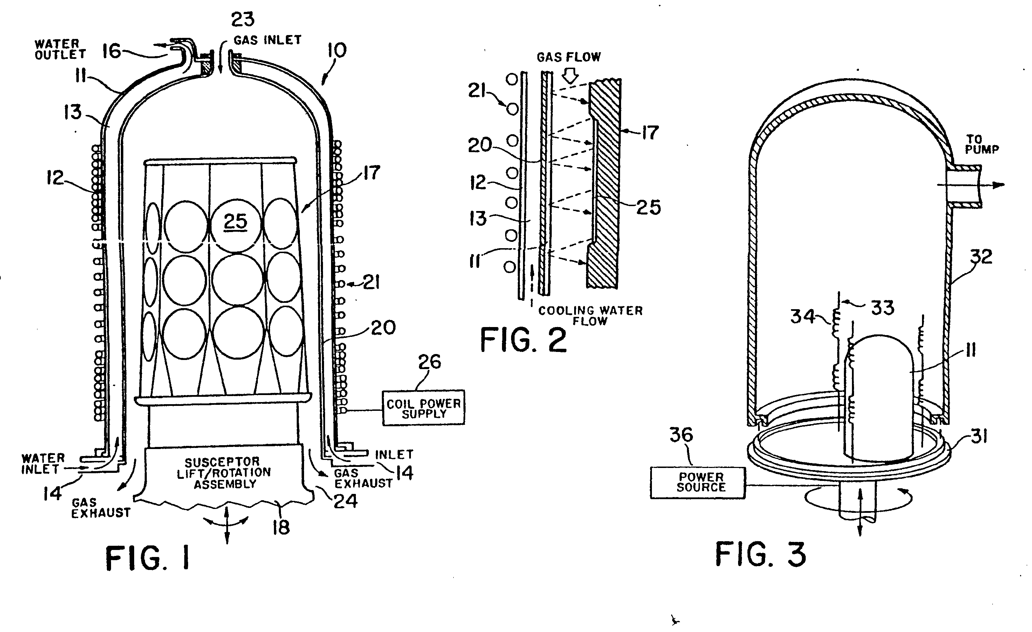

FIGS. 1 and 2 illustrate one embodiment of the high temperature epitaxial reactor system disclosed in the referenced U.S. Patent No. 4,579,080 which uses a reflective coating to decrease thermal gradients across the wafers during processing and, thus, substantially eliminate slip. The reactor system 10 includes an inner quartz bell jar 11 and a concentric outer dielectric bell jar 12 which define a water cooling channel 13 therebetween. A water inlet 14 and a water outlet 16 are provided for bringing cooling de-ionized water into the channel 13 and withdrawing the heated water from the channel. A generally cylindrical susceptor 17 is supported on a susceptor lift and rotation assembly 18 for rotating the susceptor 17 during processing of the semiconductor wafers and for moving the susceptor in and out of the inner quartz bell jar 11 for loading and unloading of the wafers 25.

An infrared reflecting coating 20 is formed on the exterior wall surface of the inner quartz bell jar 11. See FIG. 2. During chemical vapor deposition, for example, of epitaxial wafer layers the gaseous chemicals are brought into the interior of the inner bell jar 11 through a gas inlet 23. The gases flow down the sides of the cylindrical susceptor 17 and are exhausted out the bottom through gas exhaust ports 24. Deposition of the epitaxial layer on a substrate is effected by concurrently applying electric current from supply 26 to the induction coil 21, typically at a frequency within the range of about 5 to 15 kilohertz, to induce corresponding heating currents in the susceptor for heating the substrate.

As is discussed in the referenced U.S. Patent No. 4,579,080, without the reactor design disclosed therein, including the reflective coating 20, during high temperature processing, in the range of 1,000 to 1,200°C, backside heating of the wafers 25 by the susceptor can cause substantial thermal gradients through and across the substrate which, as mentioned, result in crystallographic slip.

In the illustrated reactor system 10, the inner wall or bell jar 11 is formed from a material such as quartz which is highly transparent to the infrared radiation emitted by the susceptor 17 and wafers 25. About 75 percent of the infrared energy radiated from the susceptor is transmitted to the quartz wall 11, and about 90 percent of the radiated energy in the 0.5 - 4 micron band is transmitted through the quartz layer 11 and strikes the reflecting coating 20. Thus, if the coating 20 has a suitably high reflectance value for the 0.5 - 4 micron band of infrared radiation (such as, for example 95 percent efficiency) the 75 percent of the radiated infrared energy is transmitted through the quartz wall 11 with 90 percent efficiency, reflected back by coating 20 with 95 percent efficiency and then retransmitted through the wall 11 with 90 percent efficiency, so that more than 50 percent of the energy radiated from the susceptor 17 and wafers 25 is returned to the radiating surfaces. This substantially reduces the front side wafer heat loss and the temperature gradient between the front and backside of the wafers 25. The result is the previously mentioned substantial reduction in crystallographic slip. In addition, data taken for the reactor 10 indicates that there is a substantial decrease in the power, from 70 kilowatts for a system with no reflective coating to about 50 kilowatts to the system with the reflective coating 20, required to reach a processing temperature of about 1,200°C.

In short, a coating 20 having the required uniform reflectance has the advantage of decreasing power reducing crystallographic slip and, perhaps, enhancing deposition uniformity.

The above reflectance or reflectivity estimates and the associated advantages assume nearly ideal characteristics of reflectivity as well as adhesion and durability. The preferred coating has been gold, applied in the form of widely commercially available, spray-on or painted-on, typically colloidal solutions of gold and other base metals/alloys, collectively termed "liquid gold" herein. This process involves some difficulty in achieving reproducibility and uniformity. In addition, the spray-on/paint-on solutions can be applied in maximum thicknesses of about 0,15 µm (1,500 Angstroms.) While these relatively thin coatings can provide the desired reflectivity/transmission of 96 percent/4 percent, the coatings have proven to be relatively short-lived in the harsh environment of reactors such as 10. The reasons are several.

First, although the outer surface of the inner quartz bell jar 11 and the sprayed-on/painted-on infrared reflecting coating 20 thereon are cooled by the passage of coolant fluids such as de-ionized water along the channel between the inner quartz bell jar 11 and the outer dielectric bell jar 12, nonetheless the outer wall of the inner jar 11 and the coating 20 are frequently at temperatures of about 100°C during high temperature processing.

Second, the inside wall of bell jar 11 must be cleaned periodically to remove deposits, using acids such as combinations of concentrated nitric acid and hydrofluoric acid, with the risk that the gold coating may be subject to a chemical attack. In addition, the coating is subject to scratching and abrasion during handling.

Finally and perhaps most importantly, the conventional sprayed-on/painted-on colloidal gold coatings are eroded or corroded by the de-ionized water which is used to cool the reactor. The erosion and the degradation of the adhesion, density and reflectivity of the relatively thin gold coating are manifested by peeling and flaking. This decreases the reflectivity and renders the reflectivity non-uniform across the bell jar surface after relatively short periods of use. It is then necessary to remove the bell jar from service in order to remove and replace the gold coating.

This invention provides a process for forming a high reflectivity gold-containing layer structure adhered to a quartz base comprising: forming a layer comprising principally gold with oxide-forming base metal constituents therein, on the quartz base; forming a protective polymer layer on the gold-containing layer; and heating the resulting layered structure to form oxides from said base metal constituents at the quartz base and thereby increase the adhesion of the layer to the quartz. The preferred gold coating method is vapor deposition. Liquid gold coating has also been used successfully, although the associated application uniformity and thickness qualities are not as desirable as those associated with vapor deposition.

In addition, preferably the vacuum or vapor deposited gold is formed as two layers: a thin gold alloy which provides the desired adhesion and a thicker overlayer of substantially pure gold which provides the desired reflectivity.

Regardless of which type of gold coating is used -- vapor deposited, liquid gold coated or otherwise -- heat treatment of the gold enhances adhesion between the gold coating and the quartz base material, and durability and resistance to attack by de-ionized water are enhanced by a protective overcoat of polymer material.

The following is a specific description of specific embodiments of the present invention, reference being made to the following drawing figures in which:

FIG. 1 is a partly sectional, elevational view of an induction heated cylindrical reactor system which includes an infrared reflective coating.

FIG. 2 is a schematic section diagram illustrating infrared reflecting operation of the reactor of FIG. 1.

FIG. 3 depicts one example of a vapor deposition chamber which is suitable for practicing the gold coating process of the present invention.

Detailed Description of the invention

FIG. 3 is a schematized representation of a conventional vapor deposition system 30 which can be used to form the gold coating of the present invention. The system includes a base 31 which may be adapted for vertical movement relative to the chamber cover 32 for loading and unloading of the bell jar 11, as well as for horizontal rotational movement to ensure uniform coverage of the bell jar. Resistive filament structures 33, typically of tungsten, are mounted around the bell jar position and have coils 34 which develop high temperature resistance heating upon passage of electric current therethrough from a power supply 36. The chamber is evacuated by pumps (not shown). During operation, a wire of material to be deposited such as a gold alloy of 95 percent Au, 5 percent Cr or such as 99 percent pure Au is inserted in one or more of the heating coils 34 and power is supplied to heat the wire under vacuum conditions and the bell jar 11 is rotated within the filament array to vaporize the wire and uniformly coat the outer surface of the bell jar 11.

The presently preferred process has been used successfully in prototypes of reactor 10 and involves the vacuum deposition of two layers of gold using the system 30. The first layer is a 500 to 700 Angstroms thick, 5 percent Cr, 95 percent Au alloy composition. The second, outer gold coating is a 0,6 to 0,65 µm (6,000 to 6,500 Angstroms) thick layer of 99 percent Au. The gold layers are in turn coated with a polymer coating, preferably a Vacseal™ coating 0,762 to 1,016 µm (3 to 4 mils) thick. The gold chromium/gold/polymer coating is then heated in an air oven at about 450°C for 12 - 16 hours to dry the polymer and adhere the gold layers to the quartz bell jar and to the polymer.

As mentioned, liquid gold coatings have provided generally satisfactory, although not preferred, results when covered with the polymer overcoat. The standard air oven curing of the liquid gold coating at several hundred degrees Centigrade (e.g., 500 - 1,000°C) provides adequate adhesion to the quartz. The various process considerations and specifications for the composite vapor deposited AuCr/Au/polymer coating are described below.

## Cleaning

The outside surface of the quartz bell jar must be clean for proper adhesion of the gold coating. If the jar has been coated or used previously, it is first cleared of all outside polymer and gold coatings.

Various clearing techniques can be used. For example, one sequence uses a solvent wash (typically Xylene for Vacseal™ polymer coating) for polymer removal, followed by air drying, and application of an aqua-regia wash (3:1 mixture of conc. HCl: conc. $HNO_3$) to remove the gold.

As an alternative to handling toxic solvents and aqua-regia, the outside surface can be cleared with a "bead blast" or abrasive technique to remove ≦0.5 mil of quartz material. The process removes a small amount of the quartz surface along with interface oxide compounds from the previous coating and any remaining surface impurities which could cause problems for the adhesion of subsequent coatings.

Next, the inside of the jar may be cleaned in a conventional manner, such as with dilute $HF/HNO_3$ solutions.

Optionally, following the coating removal (clearing) and interior cleaning, the bell jar may be fire polished and annealed using well-known conventional techniques. The fire polish smooths the quartz surface and removes any "haze" or surface etch effects. Annealing removes any stresses created by fire polishing.

Finally, the bell jar is cleaned preparatory to masking and applying the gold coating. This cleaning can be done in a number of ways. The presently used approach, but certainly not the only suitable one, is composed of the following steps:
1) Ionized nitrogen spray to remove static charged packing material and dust.
2) Inside rinse with de-ionized water followed by reagent grade isopropyl alcohol followed by reagent grade methanol.
3) Outside de-ionized water rinse followed by wash in detergent soap and de-ionized water rinse.
4) Outside rinse of isopropyl alcohol followed by methanol.
5) Dry/bake for two hours in air at 350°F.

## Masking

After drying, the jar is cooled and masked with tape to define the desired gold deposit and polymer overcoat boundaries. The polymer boundaries are defined outside the gold boundaries to provide edge protection for the gold.

## Vacuum Deposit

Next, and referring to FIG. 3, the masked jar 11 is placed on the rotatable fixture 31, which is inserted in the vacuum chamber 32. The quartz surface is cleaned once more by glow discharge at $25 \times 10^{-3}$ torr in air for 10 minutes, using an electrode potential of 1500V, 350mA. The chamber is then pumped down to $1 \times 10^{-4}$ Torr over 4 hours for deposition.

The gold alloy and pure gold coating steps are deposited sequentially using pressure of about $1 \times 10^{-4}$ Torr and rotating the bell jar 11. The rotational speed depends upon the speed of evaporation. Speeds of about 60 - 120 rpm are typical but not critical.

As mentioned, preferably the deposited gold is composed of two layers, the first being a 500 to 700 Angstrom thick alloy of gold and a base metal(s) such as, 5 percent Cr/95 percent Au composition, followed by a 0,6 to 0,65 μm (6,000 to 6,500 Angstrom) layer of 99 percent Au. The two-step process can be implemented without breaking chamber vacuum (i.e., in an essentially continuous process) be inserting an Au Cr wire in one filament coil array 34 and Au wire in two of the filament coil arrays, then sequentially heating the Au Cr-containing and the Au-containing filament arrays for the time required to deposit the desired thickness of material. Typically, this is about thirty seconds per array.

Typical layer thickness uniformity is 0,65 μm ± 0,05 μm (6,500 Angstrom ± 500 Angstrom,) with a pinhole density resulting in less than 4 percent light transmission over any (½ inch) 1,27 cm diameter circular area.

## Polymer Coating

Following gold deposition, the bell jar 11 is coated with polymer, preferably Vacseal™, high vacuum leak sealant to a dried thickness of approximately 0,762 to 1,016 μm (3 to 4 mils.) Vacseal™ sealant is available from Space Environment Labs, Inc., Boulder, Colorado. The coating material is sprayed on with conventional commercially available spray painting equipment utilizing dry bottled nitrogen as the propellant. The Vacseal™ sealant is used non-thinned in the pure liquid form. The coated bell jar is then air dried for about 30 minutes, followed by placement in an air oven preheated to 450°F for 12 - 16 hours. This both cures the polymer overcoat and serves as the heat treatment for the vapor deposited gold coating.

Coating reliability has been established by continuous de-ionized water immersion (of coated quartz slides) at 90 - 95° for two and one-half to three months. The coatings have survived this test without spalling or peeling and with the requisite 96 percent light transmission. In addition, the coating adhesive withstands a tape adhesion test following the immersion life test. In this test, adhesive tape is applied to the coating and quickly stripped from the coating.

Several factors are believed to cooperatively provide the combination of adhesion, durability and the resistance to corrosion by de-ionized water which characterises the coatings formed by my above-identified process. First, during testing of gold-coated slides it was discovered that vapour deposition alone provided relatively poor adhesion whereas heat-treated, polymer coated, vapour deposited gold coatings on quartz slides exhibited excellent adhesion to the quartz base material. In an attempt to determine the relevance of the polymer heat treatment, gold coatings were vapour deposited on quartz slides and one-half of each slide was left as is and the other half was overcoated with Vacseal™ sealant. The entire bell slide was then heat treated. Both the unprotected vapour-deposited gold coating and the polymer overcoated laminate exhibited excellent adhesion.

From these results and from subsequent usage it is quite apparent that the heat treatment is a crucial step in achieving adhesion between the gold chromium alloy and, perhaps, between the gold layers and the polymer overcoat. It is believed that, during heating, the chromium in the gold forms interface oxide compounds at the boundary between the gold alloy layer and the quartz which provides the excellent adhesion. Thus, since gold provides higher reflectivity than chromium or a gold chromium alloy, the preferred approach is to form a thin interfacial layer of gold-chromium alloy to promote adhesion, and use a thicker, pure gold overcoat for maximum reflectivity.

The Vacseal™ polymer coating is preferred because of its excellent high temperature characteristics. It easily withstands temperatures of 200°C, has extremely low pinhole density, exhibits excellent adhesion to quartz and to gold, has low water permeability and is easily applied and removed with appropriate solvents. In particular, the Vacseal overcoat protects the gold from attack by de-ionized water which, as mensioned, can destroy the gold within short periods of time. It is believed that the mechanism of the de-ionized water attack on the gold involves diffusion through pinholes in the gold to the interface and attack on the interface oxide compounds between the quartz and the gold which provide adhesion. The Vacseal™ polymer coating prevents the diffusion of water through the gold to the interface and, thus, preserves the gold coating with the gold-to-quartz adhesion. While Vacseal™ polymer is preferred, other polymers such as polyimides can be used which have the above-enumerated qualities, including temperature durability, low pinhole density, adhesion to gold, and low water permeability.

**Claims**

1. A process for forming a high reflectivity gold-containing layer structure adhered to a quartz base comprising:

forming a layer comprising principally gold with oxide-forming base metal constituents therein, on the quartz base;

forming a protective polymer layer on the gold-containing layer; and

heating the resulting layered structure to form oxides from said base metal constituents at the quartz base and thereby increase the adhesion of the layer to the quartz.

2. The process of Claim 1, characterised in that the gold-containing layer is deposited as a liquid.

3. The process of Claim 1, characterised in that the gold-containing layer is formed by vapor deposition.

4. The process of any of Claims 1 to 3, characterised in that a further relatively thick layer consisting essentially of gold is vacuum deposited on said gold containing layer for providing high infra-red radiation reflectivity and said polymer layer is formed on said further gold layer.

5. The process of Claim 4, characterised in that the gold containing layer layer consists essentially of gold and chromium.

6. The process of Claim 5, characterised in that the gold chromium layer is about 0.05 to 0.07μm thick and consists essentially of 5 percent chromium and 95 percent gold, and in that the further, relatively thick gold layer is approximately 0.6 to 0.65μm thick and consists essentially of gold.

7. The process of Claim 5 and Claim 6, characterised in that the gold chromium layer and the further, relatively thick gold layer are formed by vacuum deposition; and in that the material of the polymer layer is selected from the group consisting of silicone resin and polyimide.

8. The process of Claim 6 or Claim 7, characterised in that the polymer layer is approximately 0.762 to 1016μm thick.

9. A laminate for reflecting infra-red radiation through a quartz base comprising, in order; a quartz base; a thin layer consisting essentially of chromium and gold formed on the quartz; a relatively thick layer consisting essentially of gold; and a protective polymer overcoat.

10. The laminate of Claim 9, characterised in that the gold chromium layer is about 0.05 to 0.07μm thick and consists essentially of 5 percent chromium and 95 percent gold, and in that the relatively thick gold layer is approximately 0.6 to 0.65μm thick and consists essentially of gold.

11. The laminate of Claim 9, characterised in that the gold chromium layer is about 0.05 to 0.07μm thick and consists essentially of 5 percent chromium and 95 percent gold: in that the relatively thick gold layer is about 0.6 to 0.65μm thick and consists essentially of gold, and in that the polymer layer is approximately 0.762 to 1.016μm thick.

## Revendications

1. Procédé de formation d'une structure en couches contenant de l'or de grande réflectivité adhérant à un substrat de quartz, qui consiste :

à former une couche comprenant principalement de l'or renfermant des constituants métalliques de base formant des oxydes sur le substrat de quartz ;

à former une couche protectrice de polymère sur la couche contenant de l'or ; et

à chauffer la structure en couches résultante pour former des oxydes desdits constituants métalliques de base au niveau du substrat de quartz et à accroître ainsi l'adhésion de la couche au quartz.

2. Procédé suivant la revendication 1, caractérisé en ce que la couche contenant de l'or est déposée sous la forme d'un liquide.

3. Procédé suivant la revendication 1, caractérisé en ce que la couche contenant de l'or est formée par déposition en phase vapeur.

4. Procédé suivant l'une quelconque des revendications 1 à 3, caractérisé en ce qu'une autre couche relativement épaisse essentiellement constituée d'or est déposée sous vide sur ladite couche contenant de l'or pour produire la grande réflectivité à l'égard des rayons infrarouges et ladite couche de polymère est formée sur cette autre couche d'or.

5. Procédé suivant la revendication 4, caractérisé en ce que la couche contenant de l'or est essentiellement constituée d'or et de chrome.

6. Procédé suivant la revendication 5, caractérisé en ce que la couche d'or et de chrome a une épaisseur d'environ 0,05 à 0,07 μm et est essentiellement constituée de 5 pour cent de chrome et 95 pour cent d'or, et en ce que l'autre couche d'or relativement épaisse a une épaisseur approximative de 0,6 à 0,65 μm et consiste essentiellement en or.

7. Procédé suivant la revendication 5 ou la revendication 6, caractérisé en ce que la couche d'or et de chrome et l'autre couche d'or relativement épaisse sont formées par déposition sous vide ; et en ce que la matière de la couche de polymère est choisie dans le groupe comprenant une résine de silicone et un polyimide.

8. Procédé suivant la revendication 6 ou la revendication 7, caractérisé en ce que la couche de polymère a une épaisseur d'environ 0,762 à 1,016 μm.

9. Structure stratifiée pour la réflexion de rayons infrarouges à travers un substrat de quartz, qui comprend, dans l'ordre : un substrat de quartz ; une couche mince constituée essentiellement de chrome et d'or formée sur le quartz ; une couche relativement épaisse essentiellement constituée d'or ; et une surcouche protectrice de polymère.

10. Structure stratifiée suivant la revendication 9, caractérisée en ce que la couche d'or et de chrome a une épaisseur d'environ 0,05 à 0,07 μm et est essentiellement constituée de 5 pour cent de chrome et de 95 pour cent d'or, et en ce que la couche d'or relativement épaisse a une épaisseur d'environ 0,6 à 0,65 μm et est essentiellement constituée d'or.

11. Structure stratifiée suivant la revendication 9, caractérisée en ce que la couche d'or et de chrome a une épaisseur d'environ 0,05 à 0,07 μm et est essentiellement constituée de 5 pour cent de chrome et 95 pour cent d'or ; en ce que la couche d'or relativement épaisse a une épaisseur d'environ 0,6 à 0,65 μm et est essentiellement constituée d'or, et en ce que la couche de polymère a une épaisseur d'environ 0,762 à 1,016 μm.

## Patentansprüche

1. Verfahren zur Bildung eines an eine Basisschicht aus Quarz anhaftenden, ein hohes Reflexionsvermögen aufweisenden, Gold enthaltenden Schichtkörpers, das folgende Stufen umfaßt:

Ausbildung einer Schicht, die im wesentlichen Gold und darin enthaltene oxidbildende Nichtedelmetallkomponenten umfaßt, auf einer Basisschicht aus Quarz;

Ausbildung einer Polymerschutzschicht auf der Gold enthaltenden Schicht und

Erwärmung des erhaltenen Schichtkörpers zur Bildung von Oxiden aus den Nichtedelmetallkomponenten auf der Quarzbasisschicht zur Steigerung der Haftung der Schicht auf dem Quarz.

2. Verfahren nach Anspruch 1, dadurch **gekennzeichnet**, daß die Gold enthaltende Schicht in Form einer Flüssigkeit aufgebracht wird.

3. Verfahren nach Anspruch 1, dadurch **gekennzeichnet**, daß die Gold enthaltende Schicht durch Aufdampfung gebildet wird.

4. Verfahren nach einem der Ansprüche 1 bis 3, dadurch **gekennzeichnet**, daß eine weitere relativ dicke Schicht, die im wesentlichen aus Gold besteht, auf die Gold enthaltende Schicht zur Erzielung eines hohen Reflexionsvermögens für Infrarotstrahlung durch Vakuumbedampfung aufgebracht wird und die Polymerschicht auf dieser zusätzlichen Goldschicht ausgebildet wird.

5. Verfahren nach Anspruch 4, dadurch **gekennzeichnet**, daß die Gold enthaltende Schicht im wesentlichen aus Gold und Chrom besteht.

6. Verfahren nach Anspruch 5, dadurch **gekennzeichnet**, daß die Gold-Chrom-Schicht eine Dicke von ca. 0,05 bis 0,07 μm aufweist und im wesentlichen aus 5 % Chrom und 95 % Gold besteht und die zusätzliche, relativ dicke Goldschicht eine Dicke von ca. 0,6 bis 0,65 μm aufweist und im wesentlichen aus Gold besteht.

7. Verfahren nach Anspruch 5 und 6, dadurch

gekennzeichnet, daß die Gold-Chrom-Schicht und die zusätzliche, relativ dicke Goldschicht durch Vakuumbedampfung gebildet werden und das Material der Polymerschicht ausgewählt ist aus der Gruppe, bestehend aus Silikonharz und Polyimid.

8. Verfahren nach Anspruch 6 oder 7, dadurch gekennzeichnet, daß die Polymerschicht eine Dicke von ca. 0,762 bis 1,016 µm aufweist.

9. Schichtkörper für die Reflexion von Infrarotstrahlung durch eine Basisschicht aus Quarz, wobei dieser Schichtkörper eine Basisschicht aus Quarz, eine dünne Schicht, die im wesentlichen aus Chrom und Gold besteht und auf der Quarzschicht aufgebaut ist, eine relativ dicke Schicht, die im wesentlichen aus Gold besteht und eine Polymerschutzschicht umfaßt.

10. Schichtkörper nach Anspruch 9, dadurch gekennzeichnet, daß die Gold-Chrom-Schicht eine Dicke von ca. 0,05 bis 0,07 µm aufweist und im wesentlichen aus 5 % Chrom und 95 % Gold besteht und die relativ dicke Goldschicht eine Dicke von ca. 0,6 bis 0,65 µm aufweist und im wesentlichen aus Gold besteht.

11. Schichtkörper nach Anspruch 9, dadurch gekennzeichnet, daß die Gold-Chrom-Schicht eine Dicke von ca. 0,05 bis 0,07 µm aufweist und im wesentlichen aus 5 % Chrom und 95 % Gold besteht und die relativ dicke Goldschicht eine Dicke von ca. 0,6 bis 0,65 µm aufweist und im wesentlichen aus Gold besteht, und daß die Polymerschicht eine Dicke von ca. 0,762 bis 1,016 µm aufweist.

**23**

WATER OUTLET **16**    GAS INLET    **10**

**11**

**13**

**12**

**25**

**17**

**21**

**20**

COIL POWER SUPPLY    **26**

WATER INLET

**14**

GAS EXHAUST

SUSCEPTOR LIFT/ROTATION ASSEMBLY

**18**

INLET    **14**

GAS EXHAUST

**24**

**FIG. 1**

GAS FLOW

**21**

**20**

**17**

**12**

**13**

**25**

**11**

COOLING WATER FLOW

**FIG. 2**

TO PUMP

**32**

**34**    **33**

**11**

POWER SOURCE    **36**

**31**

**FIG. 3**

EP 0 237 206 B1

8